# FASCICULE DE BREVET EUROPEEN

(11) **EP 3 058 720 B1**
(45) Date de publication et mention de la délivrance du brevet: **17.07.2019**
(21) Numéro de dépôt: 14781897.5
(22) Date de dépôt: 09.10.2014
(51) Int. Cl.: H03M 1/14, H03M 1/56, H04N 5/355, H04N 5/357, H04N 5/3745, H04N 5/378

(54) **CONVERSION ANALOGIQUE NUMERIQUE À RAMPE, À MULTIPLES CONVERSIONS OU UNIQUE CONVERSION SELON LE NIVEAU DE LUMIERE REÇU PAR UN PIXEL**
ANALOG-DIGITAL-WANDLER MIT EINER RAMPE MT MEHREREN UMWANDLUNGEN ODER EINER EINZELNEN UMWANDLUNG JE NACH DEM DURCH EIN PIXEL EMPFANGENEN LICHTPEGEL
ANALOGUE DIGITAL CONVERSION WITH RAMP, WITH MULTIPLE CONVERSIONS OR A SINGLE CONVERSION DEPENDING ON THE LIGHT LEVEL RECEIVED BY A PIXEL

(30) Priorité: 14.10.2013 FR 1359940
(43) Date de publication de la demande: 24.08.2016
(73) Titulaire: Teledyne e2v Semiconductors SAS, 38120 Saint-Egrève (FR)
(72) Inventeur: GESSET, Stéphane, F-38380 Saint Laurent du Pont (FR)
(74) Mandataire: Desvignes, Agnès
(86) Numéro de dépôt international: PCT/EP2014/071683
(87) Numéro de publication internationale: WO 2015/055509

(56) Documents cités:
- EP-A1- 1 655 840
- US-A1- 2011 242 377
- US-A1- 2012 006 974
- US-A1- 2012 008 028

## Description

L'invention concerne un procédé de lecture des pixels des capteurs d'image, et plus particulièrement des capteurs d'image à grande dynamique, destinés à recueillir des images à la fois à bas niveau de luminance et à haut niveau de luminance

Un capteur d'image comprend une matrice de pixels organisée en lignes et colonnes. Les pixels d'une même colonne sont reliés à un conducteur colonne qui est lui-même relié à un circuit de lecture, pour convertir en numérique le niveau de tension appliqué sur le conducteur de colonne par un pixel sélectionné en lecture. Ce niveau de tension représente le niveau de lumière reçu par le pixel. Cette conversion est réalisée par un convertisseur analogique numérique à rampe, qui comprend un comparateur pour comparer le niveau de tension à convertir à une rampe de tension linéaire, et un compteur qui compte à haute fréquence depuis l'instant de début de la rampe jusqu'au basculement du comparateur. Le contenu du compteur à l'instant du basculement représente une valeur numérique du niveau de tension à convertir. Un tel capteur est décrit par exemple dans la demande de brevet US 2011/0242377.

Le pixel comprend principalement une photodiode et des transistors MOS, par exemple quatre transistors, qui permettent de contrôler la lecture des charges générées par la lumière dans la photodiode. Les pixels à quatre transistors fonctionnent en transférant les charges de la photodiode vers un noeud de stockage capacitif préalablement initialisé à un potentiel de réinitialisation ; la lecture du pixel comprend en général le report sur le conducteur de colonne du potentiel de réinitialisation puis du potentiel du noeud de stockage représentatif du niveau de lumière reçu par le pixel.

De manière connue, pour s'affranchir du bruit associé au noeud de stockage capacitif du pixel, qui est un bruit corrélé que l'on retrouve aussi bien sur le niveau de réinitialisation du noeud de stockage que sur le niveau utile après transfert des charges reçues, on peut effectuer une conversion analogique numérique de chacun des deux niveaux, niveau de réinitialisation et niveau utile, et on effectue une soustraction entre les deux valeurs numériques, éliminant ainsi cette composante de bruit corrélé. On peut aussi faire une soustraction analogique des tensions avant de convertir la différence. Dans ce cas, deux capacités d'échantillonnage sont utilisées pour échantillonner le signal électrique fourni par la colonne l'une après réinitialisation et l'autre après transfert des charges, avant d'effectuer une conversion différentielle.

Le circuit de lecture est dimensionné en fonction de la dynamique du capteur c'est-à-dire de la plage d'éclairements que l'on souhaite mesurer. Notamment la durée de la rampe est déterminée pour permettre la conversion du niveau d'éclairement le plus élevé que l'on souhaite mesurer, compte-tenu de la fréquence de comptage, du nombre de bits du compteur, et de la cadence de conversion souhaitée.

La dynamique de ces capteurs d'image est en pratique limitée vers les bas niveaux de luminance, par les différentes sources de bruit de la chaîne de conversion, comprenant le transistor monté en suiveur dans le pixel, pour recopier le potentiel du noeud de stockage sur le conducteur de colonne, la source de courant commune à toutes les colonnes, l'amplificateur à grand gain formant le comparateur .... Ce bruit de chaîne est complètement aléatoire et indépendant du niveau du signal à mesurer. Il constitue un frein à l'augmentation de la dynamique des capteurs vers les bas niveaux d'éclairement.

On s'intéresse plus particulièrement dans l'invention aux circuits de lecture effectuant directement une conversion analogique numérique de chacun des deux niveaux de tension fournis par la colonne, et la soustraction entre les deux valeurs numériques obtenues. Dans ce contexte en effet, on sait théoriquement réduire dans un rapport racine de n, la part d'un bruit gaussien présent dans un signal, en effectuant n conversions de ce signal et en faisant la moyenne de ces n conversions.

Mais effectuer n conversions, multiplie le temps nécessaire à la lecture d'un pixel, qui est principalement fixé par la durée nominale de la rampe, déterminée pour obtenir une large dynamique et une bonne résolution pour ces capteurs.

Pour résoudre ce problème, l'invention propose de déterminer, dans la phase de conversion analogique-numérique du niveau de tension fourni par la colonne, si ce niveau représente un bas ou un fort niveau d'éclairement, pour, dans le cas d'un bas niveau d'éclairement, réaliser n conversions et en faire la moyenne, dans le temps normalement alloué pour une seule conversion, en utilisant une rampe de durée réduite pour chacune des n conversions.

Par conséquent, l'invention propose un procédé de lecture d'un pixel dans un capteur d'image matriciel, le pixel fournissant sur un conducteur de colonne un niveau de tension représentant un niveau de lumière reçu par le pixel, et le procédé de lecture comprenant une conversion analogique-numérique au moyen d'un convertisseur à rampe comprenant une comparaison du niveau de tension reçu du conducteur de colonne à une rampe de tension analogique au moyen d'un comparateur, et un comptage d'impulsions d'horloge entre un instant de début de rampe et un instant de basculement de la sortie du comparateur.

Selon l'invention, le procédé de lecture comprend une phase de décision dans laquelle on détecte le basculement de la sortie du comparateur au bout d'un temps prédéterminé après l'instant de début de rampe, pour discriminer entre un niveau de lumière élevé, si la sortie n'a pas basculé, ou un bas niveau de lumière, si la sortie a basculé, et convertir le niveau de tension suivant respectivement un premier ou un deuxième mode de conversion où
- le premier mode de conversion comprend un unique comptage par le compteur au cours d'une fenêtre temporelle de conversion nominale à l'aide d'une rampe de durée nominale permettant la conversion d'un niveau de lumière élevé,
- le deuxième mode de conversion comprend l'établissement de n rampes successives de durée réduite pendant la durée de la fenêtre temporelle de conversion nominale, avec pour chaque rampe, un comptage par le compteur entre le début de la rampe et le basculement de la sortie du comparateur, et une sommation des n résultats de comptage, où n est un entier supérieur à 1.

La phase de décision peut être réalisée avant le début de la fenêtre temporelle de conversion nominale.

Mais elle peut aussi être réalisée au début de cette fenêtre temporelle de conversion nominale. Elle débute alors avec la rampe de tension de durée nominale, et en cas de basculement de la sortie du comparateur avant la fin de la phase de décision, la rampe de tension de durée nominale est interrompue au bout de la durée réduite et constitue la première des n rampes successives. Dans ce contexte, si on dispose d'un compteur propre à chaque colonne de la matrice de pixels, on peut réaliser directement la sommation des n comptages du deuxième mode de conversion, en prévoyant que le comptage démarre, après remise à zéro du compteur, avec la première des n rampes successives de durée réduite et reprend sans remise à zéro avec chacune des n-1 rampes de durée réduite suivantes. A la fin de la fenêtre temporelle de conversion nominale, le compteur fournit en sortie le résultat de la sommation par accumulation des n comptages.

Lorsque le procédé de lecture comprend une première conversion d'un niveau de réinitialisation, une deuxième conversion d'un niveau utile représentatif du niveau de lumière reçu par le pixel et une soustraction des résultats des deux conversions, permettant de supprimer un bruit corrélé lié à la capacité du noeud de stockage, on convertit le niveau de réinitialisation selon le deuxième mode de conversion.

Selon l'invention, dans le cas d'un niveau utile correspondant à un niveau de lumière élevé, le résultat de la conversion du niveau de réinitialisation qui est réalisé suivant le deuxième mode, est alors divisé par n avant soustraction du résultat de la conversion du niveau utile.

Dans le cas où la phase de décision est réalisée avant le début de la fenêtre temporelle de conversion nominale, on peut utiliser un compteur/décompteur propre à chaque colonne de la matrice de pixels, pour réaliser directement dans ce compteur/décompteur la soustraction des résultats des deux conversions (niveau utile-niveau de réinitialisation) : suivant le résultat de la phase de décision, on peut changer le pas de comptage du compteur de 1 à n, avant que la deuxième conversion, et le décomptage associé, ne démarre.

Plus précisément, pour la première conversion, du niveau de réinitialisation : le compteur est configuré en mode comptage avec un comptage de 1 en 1 ; puis pour la deuxième conversion, du niveau utile, on configure le compteur en mode décomptage, sans remise à zéro, avec un pas de comptage de 1 en 1 ou de n en n en fonction du résultat de la phase de décision pour cette deuxième conversion.

En pratique, on prévoit que les rampes de tension ont toutes un même niveau de départ égal au niveau de tension du conducteur de colonne lors d'une phase de réinitialisation du pixel.

L'invention concerne aussi un capteur d'image matriciel correspondant.

D'autres caractéristiques et avantages de l'invention sont donnés dans la description détaillée suivante, faite à titre indicatif et non limitatif, et en référence aux dessins annexé dans lesquels :
- la figure 1 illustre une structure classique de pixel d'un capteur d'image matriciel et de circuit de lecture associé suivant permettant un procédé de lecture selon l'art antérieur,
- la figure 2 est un chronogramme correspondant des différents signaux du circuit de lecture;
- la figure 3 représente un chronogramme des signaux de lecture d'un pixel, selon un procédé de lecture selon l'invention utilisant un premier ou un deuxième mode de conversion selon le niveau de lumière reçu par le pixel ;
- la figure 4 illustre un exemple de circuit de lecture permettant de mettre en oeuvre le procédé de lecture selon l'invention ;
- la figure 5 est un chronogramme illustrant un procédé de lecture selon l'invention, comprenant la lecture d'un niveau de réinitialisation et du niveau utile d'un pixel, dans le cas où ce niveau utile correspond à un niveau élevé de lumière;
- la figure 6 est un chronogramme illustrant un procédé de lecture selon l'invention, comprenant la lecture d'un niveau de réinitialisation et du niveau utile d'un pixel, dans le cas où ce niveau utile correspond à un bas niveau de lumière ; et
- la figure 7 illustre une variante du procédé de lecture selon l'invention, selon laquelle la décision du mode de conversion à appliquer est effectuée avant la conversion analogique-numérique.

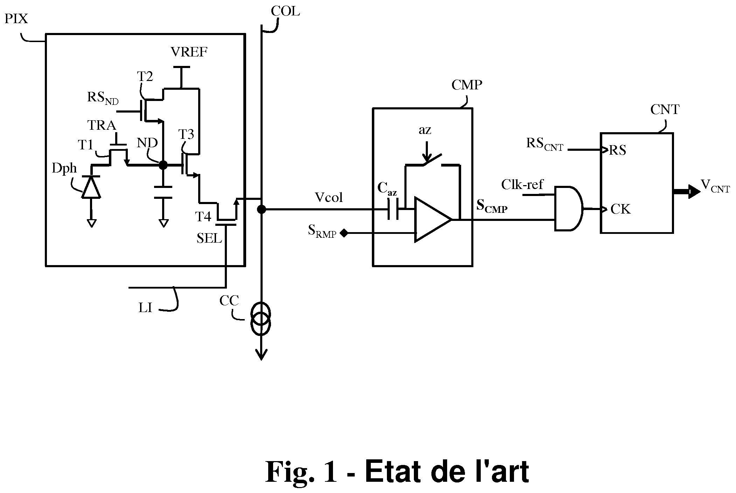

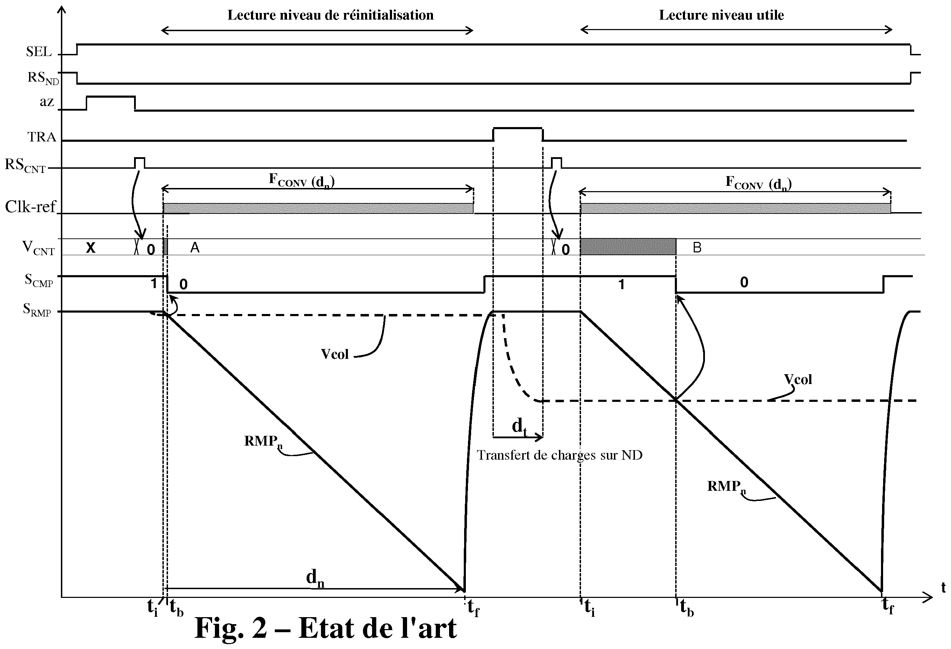

La figure 1 illustre une structure classique d'un pixel relié à un conducteur de colonne de la matrice de pixels, et un circuit de lecture de ce pixel selon l'art antérieur, réalisant une conversion analogique numérique du niveau de tension fourni par le conducteur de colonne et la figure 2 représente un chronogramme des signaux correspondants.

Le pixel PIX comprend une photodiode Dₚₕ, un noeud de stockage capacitif ND, figuré par un point auquel est reliée une capacité, un transistor de transfert de charges T1 entre la cathode de la photodiode et le noeud de stockage, un transistor T2 de réinitialisation du potentiel du noeud de stockage, un transistor suiveur T3 et un transistor T4 de sélection de ligne.

Le transistor T1 est commandé par un signal de transfert TRA. Le transistor T2 a son drain relié à un potentiel de référence noté VREF qui peut être la tension d'alimentation logique. Il est commandé par un signal RS_{ND} commandant la réinitialisation du noeud de stockage ND. Le transistor suiveur T3 a son drain relié à un potentiel fixe, dans l'exemple le potentiel VREF. Sa source est reliée au transistor de sélection de ligne T4 et sa grille est reliée au noeud de stockage ND. Le transistor T4 de sélection de ligne a sa grille reliée à un conducteur de ligne LI qui relie les grilles de tous les transistors de sélection de ligne d'une même rangée de pixels de la matrice. Le drain du transistor T4 est relié à la source du transistor T3 et sa source est reliée au conducteur de colonne COL commun à tous les pixels d'une même colonne de pixels.

Le conducteur de colonne est relié à un circuit de lecture, au pied de la colonne. Il est également relié à une source de courant CC, généralement par un transistor (non représenté) qui permet d'isoler le conducteur de colonne de la source de courant en dehors des phases de lecture des pixels. La source de courant est généralement commune à toutes les colonnes.

Lorsque le pixel est sélectionné, le transistor T3 se comporte en suiveur de tension, reportant le potentiel du noeud de stockage ND sur le conducteur de colonne.

Le circuit de lecture permet de fournir une valeur numérique V_{CNT} représentant le niveau de tension Vcol reporté sur le conducteur de colonne. Cette valeur est mise en mémoire avec les autres valeurs obtenues pour les autres pixels, pour être traitée par des circuits de traitement numérique (non représentés) de ces données. On mesure de préférence d'abord un niveau de tension après réinitialisation du noeud de stockage puis un niveau de tension après transfert dans le noeud de stockage des charges représentant l'éclairement et on fait la différence entre les deux mesures.

Le circuit de lecture comprend un convertisseur analogique numérique avec un comparateur CMP pour comparer le niveau de tension Vcol à convertir à une rampe de tension linéaire RMPₙ et un compteur CNT qui compte à haute fréquence depuis un instant tᵢ de début de la rampe jusqu'à un instant t_{b} de basculement de la sortie du comparateur. A cet instant, le contenu V_{CNT} du compteur représente une valeur numérique du niveau de tension à convertir. Ce contenu est mis en mémoire et représente une valeur d'éclairement du pixel. En pratique le contenu du compteur est initialisé à zéro avant le début tᵢ de la rampe et le démarrage du comptage est synchronisé sur le début de rampe.

Le comparateur est un amplificateur différentiel à autozéro à grand gain dont une entrée est reliée au conducteur de colonne COL, et dont l'autre entrée reçoit un signal de rampe, qui fournit une rampe de tension linéaire RMPₙ pendant une durée dₙ. Le signal de rampe S_{RMP} est fourni par un générateur de rampe linéaire par exemple un générateur utilisant une capacité chargée par une source de courant constant. Ce pourrait aussi bien être un compteur suivi d'un convertisseur numérique analogique qui fournit au premier ordre une rampe de tension linéaire, même si elle est faite avec de petites marches d'escalier.

Le générateur de rampe peut être commun à tous les circuits de lecture, c'est-à-dire à toutes les colonnes de la matrice, synchronisé, et activé dans une fenêtre temporelle de conversion nominale, de durée dₙ. La durée dₙ et la pente de la rampe RMPₙ sont déterminés pour un capteur donné pour permettre la conversion du niveau d'éclairement le plus élevé que l'on souhaite mesurer, compte-tenu de la fréquence de comptage, du nombre de bits du compteur, et de la cadence de conversion souhaitée. Le niveau de tension de rampe à l'instant t_{f} de fin de rampe correspond au niveau d'éclairement le plus élevé que l'on souhaite mesurer.

La sortie S_{CMP} du comparateur bascule lorsque les tensions sur ses deux entrées deviennent égales au cours de l'évolution de la rampe. La phase initiale d'autozéro permet de compenser les tensions de décalage ("offset") des comparateurs des différentes colonnes.

Brièvement, le procédé se déroule comme suit :
Le signal SEL qui commande la grille du transistor T4 du pixel PIX, passe au niveau actif, toute la durée du temps réservé à la lecture du pixel.

Le noeud de stockage capacitif ND du pixel est réinitialisé en appliquant une impulsion RS_{ND} au transistor T2 pour le rendre passant.

La colonne COL se charge au niveau de réinitialisation du noeud de stockage, à la tension de seuil du transistor suiveur T3 près.

On effectue d'abord une phase d'autozéro du comparateur (signal az).

Après remise à zéro du contenu V_{CNT} du compteur (RS-_{CNT}), la fenêtre temporelle de conversion nominale F_{CONV} pour la première conversion débute. Le compteur compte à une fréquence d'horloge Clk-ref depuis le début (instant tᵢ) de la rampe RMPₙ jusqu'au basculement du comparateur à un instant t_{b} qui dépend du niveau de tension sur le conducteur de colonne. Le basculement arrête le comptage.

Le contenu V_{CNT} du compteur à l'instant du basculement fournit la valeur numérique A correspondant au niveau de réinitialisation du noeud de stockage du pixel. Cette première valeur est mise en mémoire.

La fin de la fenêtre temporelle de conversion nominale, qui coïncide à l'instant t_{f} de fin de rampe linéaire RMPₙ, marque la fin de la phase de lecture du niveau de réinitialisation.

On transfère alors dans le noeud de stockage (signal TRA) les charges générées par la lumière dans la photodiode. Le contenu V_{CNT} du compteur est remis à zéro (RS-_{CNT}) et la fenêtre temporelle de conversion nominale F_{CONV} pour la deuxième conversion débute, avec une nouvelle rampe linéaire RMPₙ.

On retrouve les mêmes étapes décrites dans la phase de lecture du niveau de réinitialisation : établissement de la rampe RMPₙ, comptage, basculement du comparateur, arrêt du comptage, mise en mémoire du contenu B du compteur. La mesure numérique d'éclairement est la différence B-A.

Dans ce contexte, l'invention propose un procédé de lecture qui permet d'améliorer la dynamique du compteur vers les bas niveaux de lumière, c'est-à-dire qui permet d'améliorer le rapport signal sur bruit lorsque le signal utile est faible, sans augmenter le temps de conversion ni augmenter trop la surface de circuit de lecture.

Suivant l'invention, on prévoit deux modes de conversion, un premier qui correspond à celui précédemment décrit, avec une unique conversion dans la fenêtre temporelle de conversion nominale et un comptage qui débute avec la rampe et s'arrête au basculement de la sortie du comparateur ; et un autre mode qui prévoit de multiples conversions par comparaison à une rampe de durée réduite, dans la même fenêtre temporelle de conversion nominale. La sélection du mode de conversion à appliquer est basée sur l'observation de l'état de la sortie du comparateur après une durée prédéterminée après l'instant de début de rampe : si la sortie a basculé, le niveau utile à convertir représente un bas niveau de lumière auquel on va appliquer le deuxième mode à multiples conversions ; si la sortie n'a pas basculé, le niveau utile à convertir représente un niveau élevé de lumière et on va appliquer le premier mode à conversion unique, classique.

Pour expliquer le procédé de lecture selon l'invention, on ne s'intéresse dans un premier temps qu'à la lecture d'un niveau de tension Vcol sur une colonne COL.

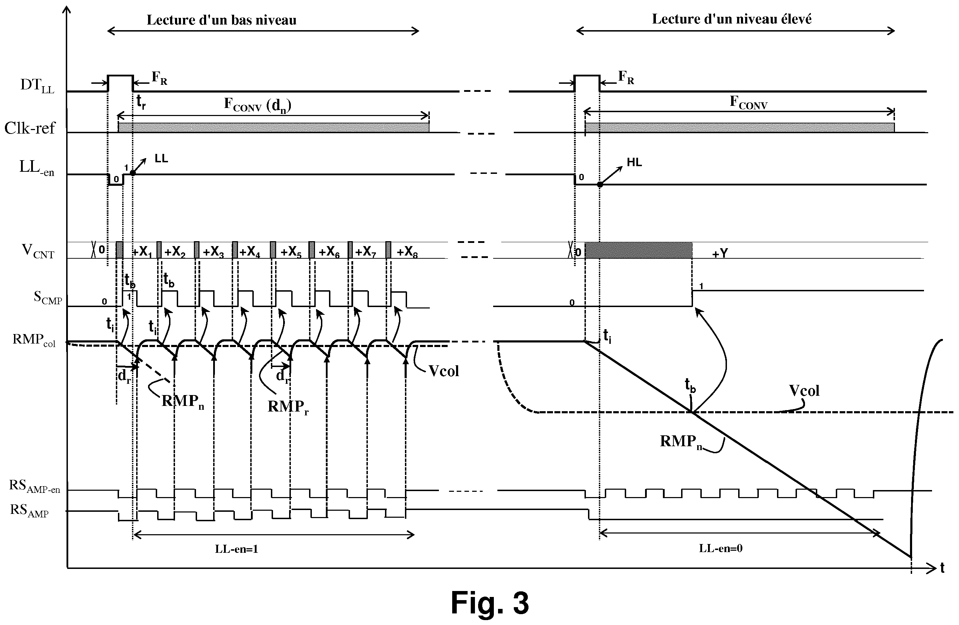

La figure 3 illustre des chronogrammes correspondant, à gauche, à la lecture d'un niveau de tension de colonne représentant un bas niveau de lumière ; à droite, à la lecture d'un niveau de tension correspondant à un niveau élevé de lumière.

Ces chronogrammes correspondent à un procédé de lecture suivant l'invention, dans une mise en oeuvre selon laquelle la phase de décision du mode de conversion à appliquer est concomitante à la phase de conversion analogique numérique du niveau de tension fourni par la colonne. Dans cette mise en oeuvre, la décision du mode de conversion à appliquer est prise à un instant tᵣ après l'instant tᵢ de début de rampe.

Chaque conversion comprend une comparaison à une rampe linéaire et un comptage qui débute avec un instant tᵢ de début de la rampe. Mais selon le mode de conversion, à conversion unique ou à multiples conversions, la rampe linéaire est la rampe RMPₙ de durée nominale dₙ, ou une rampe RMPᵣ de durée réduite dᵣ, permettant n conversions par comparaison à cette rampe RMPᵣ pendant la durée dₙ. Dans l'exemple du chronogramme de la figure 3, on a ainsi à gauche, un signal de rampe S_{RMP} qui comprend n rampes linéaires RMPᵣ successives sur la durée dₙ de la fenêtre temporelle de conversion nominale F_{CONV}, quand, à droite, on a un signal de rampe S_{RMP} qui ne comprend que la rampe linéaire RMPₙ, de durée nominale dₙ, pendant la fenêtre F_{CONV}.

Par comparaison avec le chronogramme de la figure 2, celui de la figure 3 met aussi en évidence l'ajout de la phase de décision selon l'invention. Cette phase de décision, au début de la conversion analogique-numérique, est matérialisée par la présence d'un signal DT_{LL} délimitant une fenêtre temporelle de décision F_{R}. Le circuit de lecture mémorise l'état de la sortie du comparateur à la fin (instant tᵣ) de la fenêtre de décision et fournit à partir de la fin de la fenêtre de décision un niveau logique LL₋ₑₙ indiquant si le comparateur a basculé ou non.

Ainsi dans l'exemple, si LL₋ₑₙ mémorise un "0" à l'instant tᵣ, c'est que la sortie du comparateur n'a pas basculé entre tᵢ et tᵣ. Le niveau utile traité représente donc un niveau de lumière élevé HL. La comparaison à la rampe linéaire RMPₙ se poursuit, ainsi que le comptage, débuté à l'instant tᵢ, jusqu'à l'instant t_{b} de basculement de la sortie du comparateur, où tᵢ<tᵣ<t_{b}. Le contenu V_{CNT} du compteur contient à cet instant t_{b} une valeur numérique Y qui est le résultat de la mesure. C'est le premier mode de conversion selon l'invention, qui correspond à la conversion classique décrite précédemment en référence aux figures 1 et 2 et qui est représenté à droite sur la figure 3.

Mais si LL₋ₑₙ mémorise un "1" à l'instant tᵣ, c'est que la sortie du comparateur a basculé entre tᵢ et tᵣ. Le niveau utile traité représente donc un bas niveau de lumière LL. Selon l'invention, on réalise alors n conversions pendant la durée dₙ de la fenêtre temporelle de conversion nominale F_{CONV} et une sommation des n résultats. Chacune des n conversions consiste en une comparaison à une rampe linéaire RMPᵣ de durée réduite dᵣ, et un comptage qui débute avec l'instant tᵢ de début de rampe et se termine à l'instant de basculement t_{b} de la sortie du comparateur, où tᵢ<t_{b}≤tᵣ. C'est le deuxième mode de conversion selon l'invention, représenté à gauche sur la figure 3.

En pratique l'instant tᵣ est tel qu'il s'est écoulé une durée dᵣ depuis l'instant tᵢ de début de rampe (qui est ici l'instant de début de la fenêtre de conversion F_{CONV}). Ainsi la durée dᵣ calibre le seuil de discrimination entre un niveau bas LL et un niveau haut HL, et dimensionne l'excursion des rampes de durée réduite.

Ces rampes de durée réduite dᵣ sont avantageusement obtenues à partir de la rampe RMPₙ de durée nominale dₙ, en interrompant cette rampe au bout de la durée réduite dᵣ pour la réinitialiser pour la conversion suivante.

A l'issue de chacune des n conversions à rampe de durée réduite, on obtient une valeur de comptage correspondante : X_{1,} X_{2, ...} X₈, dans l'exemple illustré avec n=8. La sommation de ces n valeurs permet ensuite au circuit de traitement numérique de manipuler une valeur moyenne : dans cette valeur moyenne, la part de bruit aléatoire gaussien, lié au bruit de chaîne (suiveur, comparateur ...) est alors significativement plus faible, d'un facteur racine de n, que si l'on avait effectué une unique conversion sur la durée nominale, suivant le premier mode de conversion.

Dans une mise en oeuvre pratique correspondant à la représentation de la figure 3, lorsque l'on dispose d'un compteur CNT par colonne, les résultats sont accumulés dans le registre du compteur au fur et à mesure des n conversions. A l'issue des n conversions, le contenu V_{CNT} du compteur est égal à la somme des n valeurs. Il peut être mémorisé pour ensuite être traité par un circuit DSP de traitement numérique du capteur. Cette accumulation dans le compteur est figurée par le signe + mis devant chacune des n valeurs de comptage X_{1,} X_{2, ...} X₈.

Différents traitements sont ensuite possibles. La division par n peut être réalisée par le circuit DSP. Ou bien, le résultat des n accumulations est mémorisé après décalage de k positions, où n=2^{k}, dans le registre du compteur, effectuant ainsi la division. Dans l'exemple où n=8=2³, il suffit de décaler le contenu du compteur de 3 positions vers la droite (côté bits de poids les moins forts (LSB)). Dans ce cas, le décalage de k positions du résultat est activé quand le signal LL₋ₑₙ est à "1" et désactivé sinon (avec les conventions utilisées LL₋ₑₙ ="1" : bas niveau et LL₋ₑₙ ="0" : niveau élevé).

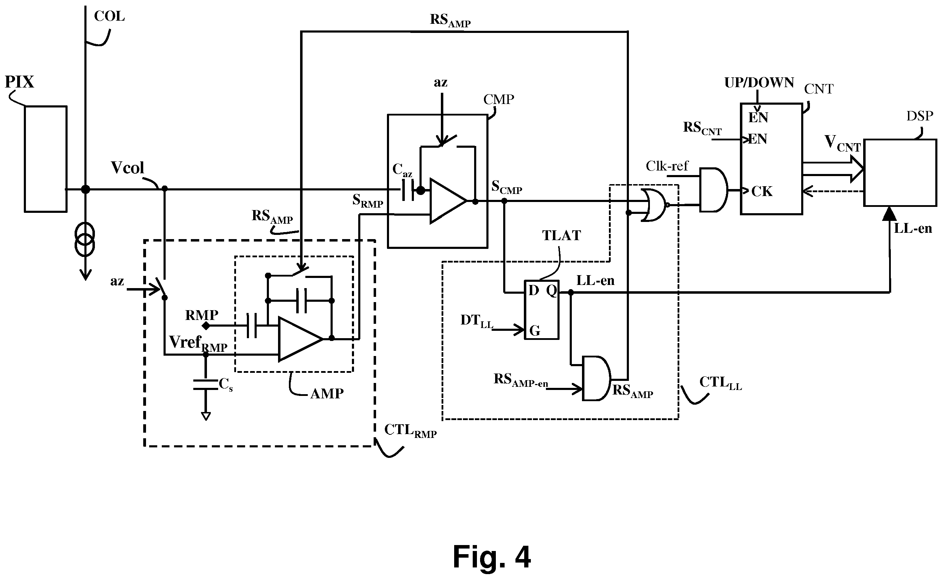

La figure 4 représente un circuit de lecture d'une colonne, apte à mettre en oeuvre un procédé de lecture d'un pixel de cette colonne qui est conforme au chronogramme des signaux de la figure 3. Ce circuit comprend un comparateur CMP, un compteur CNT, et un circuit de contrôle de rampe CTL_{RMP} et un circuit logique CTL_{LL} permettant de détecter un bas niveau de lumière et de contrôler le deuxième mode de conversion. Le circuit de contrôle de rampe reçoit une rampe de tension linéaire, de pente positive, d'un générateur de rampe commun à toutes les colonnes.

Les éléments et signaux de commande de ce circuit de lecture qui sont identiques à ceux du circuit de l'état de la technique présenté à la figure 1 portent les mêmes références. Ces éléments communs sont le comparateur CMP, qui reçoit en entrées la tension Vcol fournie par la colonne du pixel, et un signal de rampe S_{RMP}.

Ce signal de rampe S_{RMP} est délivré par le circuit CTL_{RMP} qui comprend un amplificateur (inverseur) à grand gain et à autozéro. Le gain de l'amplificateur est déterminé pour délivrer la rampe de tension linéaire RMPₙ de durée nominale dₙ avec la pente négative désirée à partir de la rampe de tension linéaire RMP appliquée à tous les circuits de lecture. Cet amplificateur à grand gain reçoit sur une entrée, une tension de référence Vref_{RMP} qui fixe le niveau de tension de départ du signal de rampe S_{RMP}. Il reçoit sur l'autre entrée, une rampe linéaire de tension RMP de pente positive, à travers une capacité. Cette rampe est fournie par un générateur, non représenté, commun à toutes les colonnes du capteur et commandé de manière appropriée pour qu'une rampe linéaire RMPₙ de durée dₙ en entrée du comparateur débute avec chaque fenêtre temporelle de conversion nominale F_{CONV}.

Le niveau Vref_{RMP} est obtenu en pratique par échantillonnage du niveau de tension fourni par la colonne après réinitialisation du pixel PIX. Ceci permet de rendre le résultat de conversion indépendant des variations de tensions de seuil des transistors suiveurs des pixels. Le circuit CTL_{RMP} comprend ainsi une capacité d'échantillonnage Cₛ de la tension de colonne Vcol sur l'entrée de référence de l'amplificateur AMP. Cette capacité d'échantillonnage est chargée au niveau de la tension de colonne Vcol après la réinitialisation du pixel PIX. En pratique on utilise le signal az de commande d'autozéro du comparateur CMP, comme signal de commande d'échantillonnage.

La sortie de l'amplificateur AMP est initialisée à ce niveau de référence Vref_{RMP} par rebouclage de sa sortie sur l'entrée de rampe RMP. Cette initialisation est commandée par un signal RS_{AMP} appliqué comme autozéro de l'amplificateur. A la fin de cette initialisation, la rampe linéaire RMPₙ à pente négative part de ce niveau de référence.

Cette initialisation de la sortie de l'amplificateur AMP est réalisée à chaque nouvelle fenêtre F_{CONV}. Dans l'exemple de mise en oeuvre de l'invention, dans laquelle on utilise la rampe nominale RMPₙ pour produire la série de rampes de durée réduite RMPᵣ, cette initialisation est aussi réalisée, périodiquement, n fois, pendant la durée de la fenêtre F_{CONV}, lorsque le signal LL-ₑₙ de détection d'un bas niveau est actif. Dans ce cas, le comptage est également périodiquement redémarré, depuis la valeur de comptage précédente, et arrêté à chaque basculement de la sortie du comparateur.

Ces fonctions de réinitialisation et de contrôle du compteur en lien avec la fonction de décision, pour assurer la conversion selon le premier mode ou le deuxième mode de conversion, avec le même circuit de lecture, sont réalisées par un circuit logique noté CTL_{LL} sur la figure 4.

La fonction de décision est réalisée par une bascule TLAT, qui reçoit en entrée de donnée D, le signal de sortie S_{CMP} du comparateur et en entrée de contrôle G, un signal DEC_{LL}, commun à toutes les colonnes, et qui délimite la fenêtre F_{R} de décision. La sortie mémoire Q de la bascule fournit le signal LL₋ₑₙ, qui recopie le signal de sortie S_{CMP} pendant la fenêtre F_{R} et le conserve en mémoire à partir du front de descente du signal DT_{LL} marquant la fin de la fenêtre F_{R}.

La fonction de réinitialisation de l'amplificateur du circuit CTL_{RMP} de contrôle de rampe, est assurée par portes logiques pour transmettre ou non un signal RS_{AMP-en} de commande de réinitialisation, en fonction de l'état du signal LL₋ₑₙ. Dans l'exemple, avec les conventions de niveau indiquées sur la figure 3, une porte ET réalise la fonction désirée, pour fournir le signal RS_{AMP}, ne recopiant le signal RS_{AMP-en} que si le signal LL₋ₑₙ est à son niveau actif signalant une conversion d'un bas niveau. Ainsi dans l'exemple, la sortie de l'amplificateur AMP est réinitialisée par rebouclage à Vref_{AMP} toutes les fois que les signaux RS_{AMP-en} et LL₋ₑₙ sont en même temps au niveau logique "1".

La fonction de transmission/inhibition du signal Clk-ref activée en cas de détection de niveau bas LL, est assurée par une porte NON OU entre le signal S_{CMP} et le signal RS_{AMP}, dont la sortie est appliquée en entrée de la porte ET qui permet de valider ou inhiber la transmission du signal d'horloge Clk-ref sur l'entrée horloge CK du compteur.

Ainsi le procédé de lecture selon l'invention peut être facilement mis en oeuvre, au moyen de circuits de logique séquentielle, par des techniques de conception habituelles. Ces circuits peuvent varier suivant les niveaux logiques actifs retenus pour les différents signaux de commande.

Dans un exemple pratique, correspondant aux chronogrammes représentés, le temps de réinitialisation du signal de rampe S_{RMP}, c'est à dire la durée des niveaux hauts des impulsions des signaux RS_{AMP-en} et RS_{AMP}, est choisi égal à la durée dᵣ des rampes RMPᵣ.

Si on utilise un compteur 10 bits permettant de compter 1024 coups d'horloge, on peut calibrer la durée réduite pour pouvoir réaliser n=4 conversions : la durée dᵣ correspond au temps qu'il faut pour compter 128 coups d'horloge ; et la durée correspondant aux 128 coups d'horloge suivants est utilisée pour réinitialiser l'amplificateur du circuit de contrôle de rampe (le comptage étant inhibé pendant ce temps). A la fin de la fenêtre F_{CONV}, on a réalisé dans le compteur la somme de 4 conversions successives. En décalant le résultat fourni par le compteur de deux bits vers la gauche, on obtient la valeur moyenne de ces 4 conversions (division par 4). Si on prend un compteur 11 bits, on pourra réaliser 8 conversions sur le même principe, et la valeur moyenne sera obtenue en décalant de 3 bits vers la gauche (division par 8). Si on prend un compteur 14 bits, permettant de compter 16384 coups d'horloge, ce sont 64 conversions, et leur sommation que l'on peut réaliser de cette façon.

Le procédé de lecture d'un pixel selon l'invention peut inclure, comme dans l'état de la technique, deux phases de conversion, la première pour mesurer un niveau de réinitialisation du noeud de stockage, la deuxième pour mesurer un niveau utile correspondant à la quantité de lumière reçue par le pixel, dans le but de soustraire ensuite les deux résultats de mesure, supprimant ainsi le bruit associé au noeud de stockage capacitif du pixel. Pour chaque phase de conversion, on associe alors une phase de décision qui permet de sélectionner le mode de conversion.

En pratique, le niveau de réinitialisation du noeud de stockage représente par définition un bas niveau de lumière. Ainsi, selon l'invention la phase de conversion du niveau de réinitialisation utilisera ainsi le deuxième mode de conversion, à multiples conversions par comparaison à une rampe de durée réduite dᵣ.

La phase de conversion du niveau utile sera effectuée suivant le premier mode de conversion s'il correspond à un niveau élevé de lumière, et suivant le deuxième mode de conversion dans le cas contraire.

Pour effectuer la soustraction des deux résultats, ces résultats doivent être homogènes.

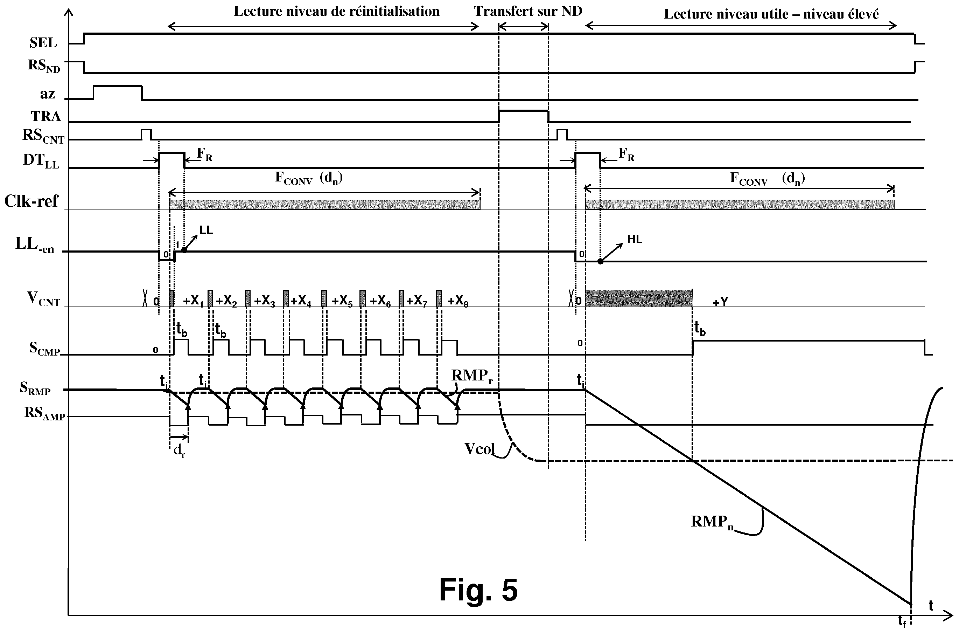

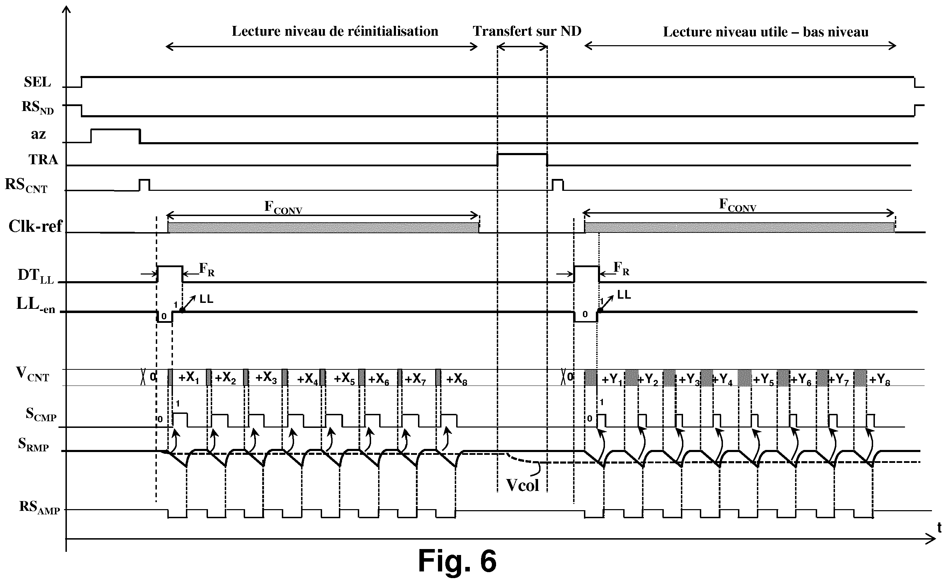

Les figures 5 et 6 illustrent respectivement ce qui se passe alors lorsque le niveau utile représente un bas niveau de lumière (figure 5) ou un niveau élevé (figure 6).

Dans le cas représenté à la figure 5, les deux conversions sont réalisées toutes les deux suivant le deuxième mode de conversion, avec n conversions de durée réduite et accumulation des n résultats comme décrit en relation avec la figure 3. On peut prévoir une mémorisation des deux résultats accumulés, suivie d'une soustraction par le circuit de traitement numérique. Une division par n peut être réalisée ensuite.

Dans le cas représenté à la figure 6, le niveau utile est lui réalisé suivant le premier mode de conversion, classique. La soustraction du résultat correspondant au niveau de réinitialisation ne peut se faire qu'après division par n du résultat mémorisé pour le niveau de réinitialisation.

On prévoit alors que l'état du signal logique LL₋ₑₙ est mémorisé avec le résultat final de chaque conversion. Ainsi, si LL₋ₑₙ est à "1" pour le niveau utile, le circuit DSP fera la soustraction des deux résultats mémorisés à l'issue de chaque fenêtre de conversion nominale. Si LL₋ₑₙ est à "0" pour le niveau utile, le circuit DSP fera d'abord la division par k du résultat correspondant à la mesure du niveau de réinitialisation, puis la soustraction des deux résultats.

On notera que le procédé de lecture qui vient d'être décrit peut aussi s'appliquer quand on utilise un unique compteur pour toutes les colonnes. Dans ce cas, il faut prévoir de mémoriser pour chacune des n conversions, la valeur du compteur au début et à la fin du comptage. C'est ensuite le circuit DSP qui détermine la valeur de comptage pour chacune des n conversions, par soustraction, puis la valeur moyenne de ces n conversions.

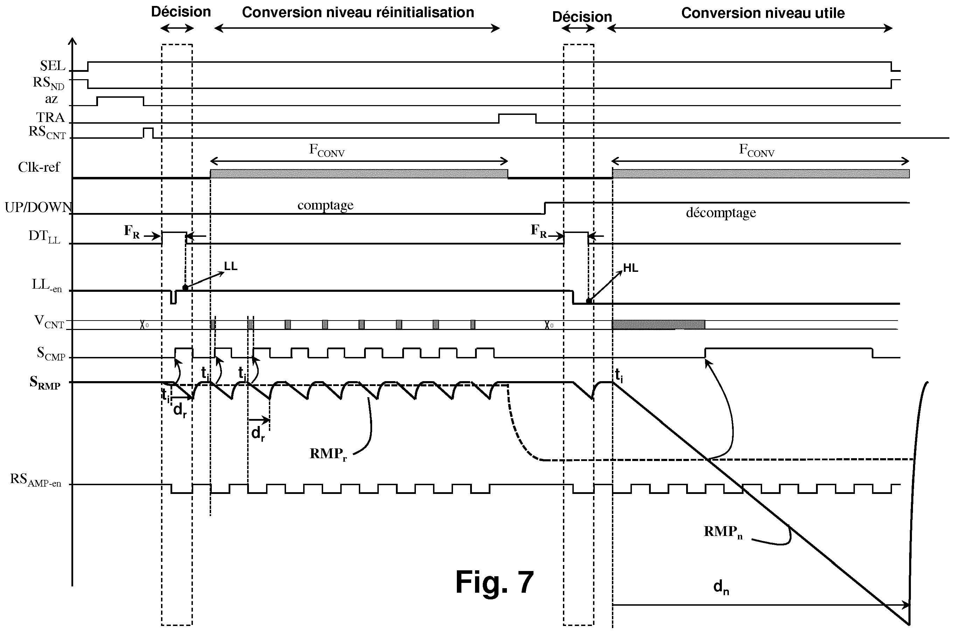

La figure 7 illustre une variante du procédé de lecture selon l'invention, dans laquelle la phase de décision n'est plus concomitante à la conversion, mais préalable à cette phase.

Elle utilise comme précédemment une comparaison à une rampe de durée réduite, et la recopie de la sortie S_{CMP} du comparateur, à partir de l'instant de début de rampe ou un peu avant, jusqu'à la fin de la rampe. La fin de cette rampe marque le début de la fenêtre temporelle de conversion nominale, pour le niveau à convertir. Ainsi la fenêtre de recopie et la fenêtre de conversion ne se recouvrent pas, la première se terminant à l'instant tᵣ avant que la seconde ne débute.

On notera que pendant cette phase de décision, c'est-à-dire pendant la durée de la fenêtre de recopie F_{R}, le compteur n'est pas actif. Il n'est activé que pendant la fenêtre temporelle de conversion nominale F_{CONV}.

La phase de décision peut avantageusement utiliser comme rampe, la rampe nominale utilisée pour les phases de conversion, qui est alors interrompue à l'expiration de la durée dᵣ après l'instant tᵢ de début de rampe suivant le même mécanisme de réinitialisation de l'amplificateur AMP déjà décrit. C'est ce qui est illustré.

Mais elle pourrait utiliser sa propre rampe, notamment une rampe ayant une pente plus élevée, et par suite une durée qui peut être plus courte, permettant une décision plus rapide. En effet, dans cette phase de décision, on ne cherche pas à convertir avec précision, mais seulement à déterminer le mode de conversion à utiliser ensuite. Cette rampe spécifique pourrait être fournie à partir du générateur de rampe RMP commun aux colonnes, en utilisant un autre amplificateur à grand gain et des signaux de commande d'initialisation et d'échantillonnage associés.

Cette variante du procédé de lecture avec une phase de décision préalable à la phase de conversion, permet de réaliser directement dans le compteur CNT, la soustraction entre le résultat obtenu par la conversion du niveau de réinitialisation et celui obtenu par la conversion du niveau utile. On utilise le compteur en mode comptage pour la première conversion (niveau de réinitialisation), puis en mode décomptage pour la seconde conversion (niveau utile), avec pour ce dernier un paramétrage du pas de décomptage, de 1 en 1 ou de n en n, en fonction de l'état du signal LL₋ₑₙ pendant la fenêtre F_{CONV}.

En effet si le niveau utile représente un bas niveau de lumière, le signal LL₋ₑₙ est à 1. Le niveau utile va être converti suivant le même mode à multiples conversions que le niveau de réinitialisation. Les résultats sont homogènes. On paramètre alors le compteur pour décompter de 1 en 1.

Mais si le niveau utile représente un niveau de lumière élevé, le signal LL₋ₑₙ est à 0. Le niveau utile va être converti suivant le mode classique à unique comptage. Les résultats ne sont pas homogènes. On paramètre alors le compteur pour décompter de n en n.

Réaliser la soustraction des résultats dans le compteur par comptage puis décomptage, suppose que l'on dispose d'un compteur par colonne ; Cela suppose aussi que le contenu du compteur ne soit pas réinitialisé entre la première phase de conversion et la deuxième phase de conversion : en d'autres termes que le décomptage opère sur le résultat du comptage.

La mise en oeuvre de cette variante nécessite ainsi quelques signaux de commande et séquencement supplémentaires ou modifiés, notamment pour paramétrer correctement le compteur pour chaque phase de conversion. Il s'agit notamment du signal UP/DOWN paramétrant le compteur en mode comptage pour la première phase de conversion et en mode décomptage pour la deuxième phase de conversion (niveau utile) et des signaux permettant de configurer le pas de comptage du compteur : toujours de 1 en 1 en mode comptage ; et de 1 en 1 ou de n en n dans le mode décomptage, en fonction de l'état du signal LL₋ₑₙ. Ceci peut par exemple être réalisé par paramétrage d'un registre du compteur prévu à cet effet.

## Revendications

1. Procédé de lecture d'un pixel (PIX) dans un capteur d'image matriciel, le pixel fournissant sur un conducteur de colonne (COL) un niveau de tension (Vcol) représentant un niveau de lumière reçu par le pixel, et le procédé de lecture comprenant une conversion analogique-numérique au moyen d'un convertisseur à rampe comprenant une comparaison du niveau de tension reçu du conducteur de colonne à une rampe linéaire de tension analogique au moyen d'un comparateur (CMP), et un comptage d'impulsions d'horloge entre un instant (ti) de début de rampe et un instant de basculement (tb) de la sortie du comparateur,
**caractérisé en ce que** le procédé de lecture comprend une phase de détection du basculement de la sortie du comparateur au bout d'un temps prédéterminé (td) après l'instant (ti) de début de rampe, pour discriminer entre un niveau de lumière élevé (HL), si la sortie n'a pas basculé, ou un bas niveau de lumière (LL), si la sortie a basculé et convertir le niveau de tension suivant respectivement un premier ou un deuxième mode de conversion où
- le premier mode de conversion comprend un unique comptage par le compteur au cours d'une fenêtre temporelle de conversion nominale (F_{CONV}) à l'aide d'une rampe (RMPₙ) de durée nominale (dₙ) permettant la conversion d'un niveau de lumière élevé,
- le deuxième mode de conversion comprend l'établissement de n rampes successives (RMPᵣ) de durée réduite (dᵣ) pendant la durée de la fenêtre temporelle de conversion nominale, avec pour chaque rampe, un comptage par le compteur entre le début de la rampe et le basculement de la sortie du comparateur, et une sommation des n résultats de comptage, où n est un entier supérieur à 1, permettant la conversion d'un niveau de lumière bas.

2. Procédé de lecture selon la revendication 1, dans lequel l'étape de détection est réalisée en parallèle de la conversion analogique-numérique du niveau de tension de colonne dans la fenêtre temporelle de conversion nominale et débute avec la rampe de tension de durée nominale,
**caractérisé en ce que**, en cas de basculement de la sortie du comparateur avant la fin de la phase de décision, la rampe de tension de durée nominale (dₙ) est interrompue au bout de la durée réduite (dᵣ) et constitue la première des n rampes successives.

3. Procédé de lecture selon la revendication 2, utilisant un compteur propre à chaque colonne de la matrice de pixels, **caractérisé en ce que** dans le deuxième mode de conversion, le comptage démarre, après remise à zéro, avec la première des n rampes successives de durée réduite, et reprend sans remise à zéro avec chacune des n-1 rampes de durée réduite suivantes, le compteur fournissant en sortie le résultat de la sommation par accumulation des n comptages.

4. Procédé de lecture selon la revendication 3, dans lequel le pixel comprend un noeud de stockage (ND) de charges qui est réinitialisé avant de recevoir les charges engendrées par la lumière, le procédé comprenant une première conversion d'un niveau de réinitialisation, une deuxième conversion d'un niveau utile représentatif du niveau de lumière reçu par le pixel et une soustraction des résultats des deux conversions, **caractérisé en ce que** dans le cas d'un niveau utile correspondant à un fort niveau de lumière, le résultat de la conversion du niveau de réinitialisation qui est réalisé suivant le deuxième mode, est divisé par n avant soustraction du résultat de la conversion du niveau utile.

5. Procédé de lecture selon la revendication 1 dans lequel la phase de détection est réalisée avant la conversion analogique numérique, et comprend une comparaison du niveau de tension à la rampe de durée de tension nominale et la détection de l'état de la sortie du comparateur à un instant prédéterminé (tᵣ) après l'instant (tᵢ) de début de rampe.

6. Procédé de lecture selon la revendication 5, dans lequel le pixel comprend un noeud de stockage (ND) de charges qui est réinitialisé avant de recevoir les charges engendrées par la lumière, le procédé comprenant une première conversion d'un niveau de réinitialisation, une deuxième conversion d'un niveau utile représentatif du niveau de lumière reçu par le pixel et une soustraction des résultats des deux conversions, **caractérisé en ce que** la soustraction est réalisée directement dans un compteur/décompteur propre à chaque colonne de la matrice de pixels, en commandant le compteur
- pour la première conversion, du niveau de réinitialisation, en mode comptage et de 1 en 1 puis
- pour la deuxième conversion, du niveau utile, en mode décomptage sans remise à zéro, et avec un décomptage de 1 en 1 ou de n en n en fonction du résultat (LL₋ₑₙ) de la phase de décision correspondante.

7. Procédé de lecture selon l'une quelconque des revendications 1 à 6, dans lequel les rampes de tension ont toutes un même niveau de départ (Vref_{RMP}) égal au niveau de tension du conducteur de colonne lors d'une phase de réinitialisation du pixel.

8. Capteur d'image matriciel comprenant une matrice de pixels organisée en lignes et colonnes, les pixels d'une même colonne étant reliés à un conducteur colonne (COL) relié à un circuit de lecture, un pixel sélectionné en lecture fournissant sur le conducteur de colonne un niveau de tension (Vcol) représentant un niveau de lumière reçu par le pixel, et le circuit de lecture comprenant un convertisseur analogique-numérique à rampe comprenant un comparateur (CMP) pour comparer le niveau de tension reçu du conducteur de colonne à une rampe linéaire de tension analogique, et un compteur (CNT) d'impulsions d'horloge (Clk-ref) qui compte entre un instant (ti) de début de rampe et un instant de basculement (tb) de la sortie du comparateur,
**caractérisé en ce que** le circuit de lecture comprend un circuit de sélection d'un premier mode de conversion ou d'un deuxième mode de conversion, selon que la sortie du comparateur n'a pas basculé, ou a basculé, au bout d'un temps prédéterminé (tr) après l'instant de début de rampe, où
- le premier mode de conversion comprend un unique comptage par le compteur au cours d'une fenêtre temporelle de conversion nominale à l'aide d'une rampe (RMPₙ) de durée nominale (dₙ) permettant la conversion d'un niveau de lumière élevé,
- le deuxième mode de conversion comprend, l'établissement de n rampes (RMPᵣ) successives de durée réduite (dᵣ) pendant la durée (dₙ) de la fenêtre temporelle de conversion nominale (F_{CONV}), avec pour chaque rampe, un comptage par le compteur entre le début de la rampe et le basculement de la sortie (S_{CMP}) du comparateur, et une sommation des n résultats de comptage, où n est un entier supérieur à 1, permettant la conversion d'un niveau de lumière bas.

## Patentansprüche

1. Verfahren zum Lesen eines Pixels (PIX) in einem Matrixbildsensor, wobei das Pixel auf einem Spaltenleiter (COL) einen Spannungspegel (Vcol) liefert, der ein von dem Pixel empfangenes Lichtniveau repräsentiert, und wobei das Leseverfahren eine Analog-Digital-Umwandlung mittels eines Rampenwandlers beinhaltet, die einen Vergleich des vom Spaltenleiter empfangenen Spannungspegels mit einer analogen linearen Spannungsrampe mittels eines Komparators (CMP) und eine Taktimpulszählung zwischen einem Rampenanfangsmoment (ti) und einem Umschaltmoment (tb) des Ausgangs des Komparators beinhaltet,
**dadurch gekennzeichnet, dass** das Leseverfahren eine Phase des Erkennens des Umschaltens des Ausgangs des Komparators am Ende einer vorbestimmten Zeit (td) nach dem Rampenanfangsmoment (ti) beinhaltet, um zwischen einem erhöhten Lichtniveau (HL), wenn der Ausgang nicht umgeschaltet wurde, und einem niedrigen Lichtniveau (LL) zu unterscheiden, wenn der Ausgang umgeschaltet wurde, und den Spannungspegel jeweils nach einem ersten oder einem zweiten Umwandlungsmodus umzuwandeln, wobei
- der erste Umwandlungsmodus eine einzige Zählung durch den Zähler im Verlauf eines nominellen Umwandlungszeitfensters (F_{CONV}) mit Hilfe einer Rampe (RMPₙ) einer nominellen Dauer (dₙ) beinhaltet, die das Umwandeln von einem erhöhten Lichtniveau zulässt,
- der zweite Umwandlungsmodus das Einrichten von n sukzessiven Rampen (RMPᵣ) von reduzierter Dauer (dᵣ) während der Dauer des nominellen Umwandlungszeitfensters beinhaltet, für jede Rampe mit einer Zählung durch den Zähler zwischen dem Anfang der Rampe und dem Umschalten des Ausgangs des Komparators, und einer Summierung von n Zählresultaten, wobei n eine ganze Zahl größer als 1 ist, die die Umwandlung eines niedrigen Lichtniveaus zulässt.

2. Leseverfahren nach Anspruch 1, bei dem der Erkennungsschritt parallel zur Analog-Digital-Umwandlung des Spaltenspannungspegels im nominellen Umwandlungszeitfenster erfolgt und mit der Spannungsrampe von nomineller Dauer beginnt, und dadurch, dass im Falle des Umschaltens des Ausgangs des Komparators vor dem Ende der Entscheidungsphase die Spannungsrampe von nomineller Dauer (dₙ) am Ende der reduzierten Dauer (dᵣ) unterbrochen wird und die erste der n sukzessiven Rampen bildet.

3. Leseverfahren nach Anspruch 2 unter Verwendung eines jeder Spalte der Pixelmatrix eigenen Zählers, **dadurch gekennzeichnet, dass** im zweiten Umwandlungsmodus die Zählung nach dem Zurückstellen auf null mit der ersten von n sukzessiven Rampen von reduzierter Dauer beginnt und ohne Rückstellung auf null mit jeder der n-1 nachfolgenden Rampen von reduzierter Dauer fortgesetzt wird, wobei der Zähler am Ausgang das Ergebnis der Summierung durch Akkumulation von n Zählergebnissen liefert.

4. Leseverfahren nach Anspruch 3, bei dem das Pixel einen Ladungsspeicherknoten (ND) umfasst, der vor dem Empfang der durch das Licht erzeugten Lasten neu initialisiert wird, wobei das Verfahren eine erste Umwandlung eines Neuinitialisierungsniveaus, eine zweite Umwandlung eines nützlichen Niveaus, das das von dem Pixel empfangene Lichtniveau repräsentiert, und eine Subtraktion der Ergebnisse der beiden Umwandlungen beinhaltet, **dadurch gekennzeichnet, dass** im Falle eines nützlichen Niveaus entsprechend einem hohen Lichtniveau das Ergebnis der Umwandlung des Neuinitialisierungsniveaus, die nach dem zweiten Modus erfolgt, vor der Subtraktion des Ergebnisses der Umwandlung des nützlichen Niveaus durch n dividiert wird.

5. Leseverfahren nach Anspruch 1, bei dem die Erkennungsphase vor der Analog-Digital-Umwandlung erfolgt und einen Vergleich des Spannungspegels mit der Spannungsrampe von nomineller Dauer und die Erkennung des Zustands des Ausgangs des Komparators in einem vorbestimmten Moment (tᵣ) nach dem Rampenanfangsmoment (tᵢ) beinhaltet.

6. Leseverfahren nach Anspruch 5, bei dem das Pixel einen Ladungsspeicherknoten (ND) umfasst, der vor dem Empfang der durch das Licht erzeugten Lasten neu initialisiert wird, wobei das Verfahren eine erste Umwandlung eines Neuinitialisierungsniveaus, eine zweite Umwandlung eines nützlichen Niveaus, das das von dem Pixel empfangene Lichtniveau repräsentiert, und eine Subtraktion der Ergebnisse der beiden Umwandlungen beinhaltet, **dadurch gekennzeichnet, dass** die Subtraktion direkt in einem jeder Spalte der Pixelmatrix eigenen Vor-/Rückwärtszähler erfolgt, durch Steuern des Zählers
- für die erste Umwandlung des Neuinitialisierungsniveaus, im Vorwärtszählmodus und von 1 bis 1, dann
- für die zweite Umwandlung des nützlichen Niveaus im Rückwärtszählmodus, ohne Rückstellung auf null und mit einer Rückwärtszählung von 1 bis 1 oder von n bis n in Abhängigkeit von dem Ergebnis (LL₋ₑₙ) der entsprechenden Entscheidungsphase.

7. Leseverfahren nach einem der Ansprüche 1 bis 6, bei dem die Spannungsrampen alle ein selbes Ausgangsniveau (Vref_{RMP}) gleich dem Spannungspegel des Spannungsleiters während einer Neuinitialisierungsphase des Pixels haben.

8. Matrixbildsensor, der eine in Reihen und Spalten organisierte Pixelmatrix umfasst, wobei die Pixel einer selben Spalte mit einem Spaltenleiter (COL) verbunden sind, der mit einer Leseschaltung verbunden ist, wobei ein zum Lesen ausgewähltes Pixel auf dem Spaltenleiter einen Spannungspegel (Vcol) liefert, der ein von dem Pixel empfangenes Lichtniveau repräsentiert, und wobei die Leseschaltung einen Analog-Digital-Rampenwandler umfasst, umfassend einen Komparator (CMP) zum Vergleichen des vom Spannungsleiters empfangenen Spannungspegels mit einer linearen analogen Spannungsrampe, und einen Taktimpuls-(Clk-ref)-Zähler (CNT), der zwischen einem Rampenanfangsmoment (ti) und einem Umschaltmoment (tb) des Ausgangs des Komparators zählt,
**dadurch gekennzeichnet, dass** die Leseschaltung eine Schaltung zum Auswählen eines ersten Umwandlungsmodus oder eines zweiten Umwandlungsmodus umfasst, je nachdem, ob der Ausgang des Komparators am Ende einer vorbestimmten Zeit (tr) nach dem Rampenanfangsmoment umgeschaltet wurde oder nicht, wobei
- der erste Umwandlungsmodus eine einzige Zählung durch den Zähler im Verlaufe eines nominellen Umwandlungszeitfensters mit Hilfe einer Rampe (RMPₙ) von nomineller Dauer (dₙ) beinhaltet, die die Umwandlung eines erhöhten Lichtniveaus zulässt,
- der zweite Umwandlungsmodus das Einrichten von n sukzessiven Rampen (RMPᵣ) von reduzierter Dauer (dᵣ) während der Dauer (dₙ) des nominellen Umwandlungszeitfensters (F_{CONV}) beinhaltet, für jede Rampe mit einer Zählung durch den Zähler zwischen dem Anfang der Rampe und dem Umschalten des Ausgangs (S_{CMP}) des Komparators, und eine Summierung von n Zählergebnissen, wobei n eine ganze Zahl größer als 1 ist, die die Umwandlung eines niedrigen Lichtniveaus zulässt.

## Claims

1. Method for reading a pixel (PIX) in a matrix image sensor, the pixel providing on a column conductor (COL) a voltage level (Vcol) representing a light level received by the pixel, and the method of reading comprising an analogue-digital conversion by means of a ramp-type converter comprising a comparison of the voltage level received from the column conductor with a linear analogue voltage ramp by means of a comparator (CMP), and a counting of clock pulses between an instant (ti) of ramp start and an instant of toggling (tb) of the output of the comparator,
**characterized in that** the method of reading comprises a phase of detecting the toggling of the output of the comparator after a predetermined time (td) after the instant (ti) of ramp start, to discriminate between a high light level (HL), if the output has not toggled, or a low light level (LL), if the output has toggled and convert the voltage level in accordance with respectively a first or a second mode of conversion where
- the first mode of conversion comprises a single counting by the counter in the course of a nominal conversion time window (F_{CONV}) with the aid of a ramp (RMPₙ) of nominal duration (dₙ) allowing the conversion of a high light level,
- the second mode of conversion comprises the establishment of n successive ramps (RMPᵣ) of reduced duration (dᵣ) over the duration of the nominal conversion time window, with for each ramp, a counting by the counter between the start of the ramp and the toggling of the output of the comparator, and a summation of the n counting results, where n is an integer greater than 1, allowing the conversion of a low light level.

2. Reading method according to claim 1, in which the detection step is carried out in parallel with the analogue-digital conversion of the column voltage level in the nominal conversion time window and starts with the voltage ramp of nominal duration, and in that, should the output of the comparator toggle before the end of the decision phase, the voltage ramp of nominal duration (dₙ) is interrupted after the reduced duration (dᵣ) and constitutes the first of the n successive ramps.

3. Reading method according to claim 2, using a counter specific to each column of the matrix of pixels, **characterized in that** in the second mode of conversion, the counting commences, after resetting to zero, with the first of the n successive ramps of reduced duration, and resumes without resetting to zero with each of the n-1 following ramps of reduced duration, the counter providing as output the result of the summation by accumulation of the n countings.

4. Reading method according to claim 3, in which the pixel comprises a charge storage node (ND) which is reinitialized before receiving the charge engendered by the light, the method comprising a first conversion of a reinitialization level, a second conversion of a useful level representative of the light level received by the pixel and a subtraction of the results of the two conversions, **characterized in that** in the case of a useful level corresponding to a high light level, the result of the conversion of the reinitialization level which is carried out according to the second mode, is divided by n before subtraction of the result of the conversion of the useful level.

5. Reading method according to claim 1, in which the detection phase is carried out before the analogue-digital conversion, and comprises a comparison of the voltage level with the nominal voltage duration ramp and the detection of the state of the output of the comparator at a predetermined instant (tᵣ) after the instant (tᵢ) of ramp start.

6. Reading method according to claim 5, in which the pixel comprises a charge storage node (ND) which is reinitialized before receiving the charge engendered by the light, the method comprising a first conversion of a reinitialization level, a second conversion of a useful level representative of the light level received by the pixel and a subtraction of the results of the two conversions, **characterized in that** the subtraction is carried out directly in an up-counter/down-counter specific to each column of the matrix of pixels, by controlling the counter
- for the first conversion, of the reinitialization level, in 1 by 1 counting mode and then
- for the second conversion, of the useful level, in countdown mode without resetting to zero, and with a 1 by 1 or n by n countdown as a function of the result (LL₋ₑₙ) of the corresponding decision phase.

7. Reading method according to any one of claims 1 to 6, in which the voltage ramps all have one and the same starting level (Vref_{RMP}) equal to the voltage level of the column conductor during a phase of reinitializing the pixel.

8. Matrix image sensor comprising a matrix of pixels organized into rows and columns, the pixels of one and the same column being linked to a column conductor (COL) linked to a reading circuit, a selected pixel for reading providing on the column conductor, a voltage level (Vcol) representing a light level received by the pixel, and the reading circuit comprising a ramp-type analogue-digital converter comprising a comparator (CMP) for comparing the voltage level received from the column conductor with a linear analogue voltage ramp, and a counter (CNT) of clock pulses (Clk-ref) which counts between an instant (ti) of ramp start and an instant of toggling (tb) of the output of the comparator,
**characterized in that** the reading circuit comprises a circuit for selecting a first mode of conversion or a second mode of selection, depending on whether the output of the comparator has not toggled, or has toggled, after a predetermined time (tr) after the instant of ramp start, where
- the first mode of conversion comprises a single counting by the counter in the course of a nominal conversion time window with the aid of a ramp (RMPₙ) of nominal duration (dₙ) allowing the conversion of a high light level,
- the second mode of conversion comprises the establishment of n successive ramps (RMPᵣ) of reduced duration (dᵣ) over the duration (dₙ) of the nominal conversion time window (F_{CONV}), with for each ramp, a counting by the counter between the start of the ramp and the toggling of the output (S_{CMP}) of the comparator, and a summation of the n counting results, where n is an integer greater than 1, allowing the conversion of a low light level.
